# EUROPEAN PATENT APPLICATION

(11) **EP 3 499 714 A1**
(43) Date of publication of application: **19.06.2019**
(21) Application number: 18212465.1
(22) Date of filing: 13.12.2018
(51) Int. Cl.: H03F 1/30, H03F 3/30, H03F 3/45, H03F 1/32, H03F 1/02, H03F 1/34

(54) **AMPLIFICATION DEVICE**

(30) Priority: 18.12.2017 JP 2017241395
(71) Applicant: Onkyo Corporation, Osaka 572-0028 (JP)
(72) Inventor: YOSHIDA, Makoto, Osaka, Osaka 572-0028 (JP)
(74) Representative: Horn Kleimann Waitzhofer Patentanwälte PartG mbB

(57) **Abstract**

An amplification device (1) includes an operational amplifier (U1) which amplifies an input signal, a diamond buffer circuit (2) to which the signal which is amplified by the operational amplifier (U1) is input, and first and second current mirror circuits (3, 4). The first current mirror circuit (3) is connected to a positive side power supply (V1) and the diamond buffer circuit (2), and is connected to a positive side power supply terminal of the operational amplifier (U1). The second current mirror circuit (4) is connected to a negative side power supply (V2) and the diamond buffer circuit (2), and is connected to a negative side power supply terminal of the operational amplifier (U1).

## Description

### TECHNICAL FIELD

The present invention relates to an amplification device which amplifies a signal.

### BACKGROUND ART

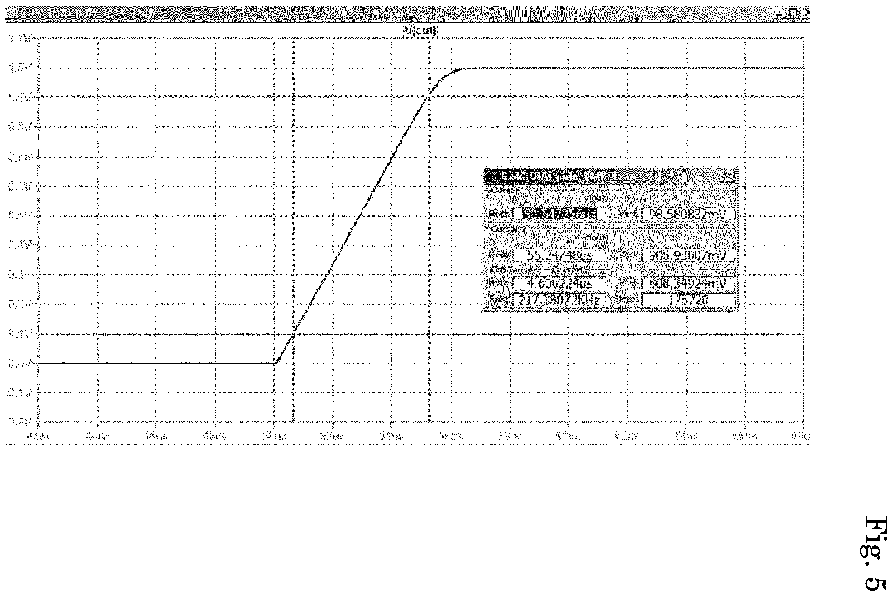

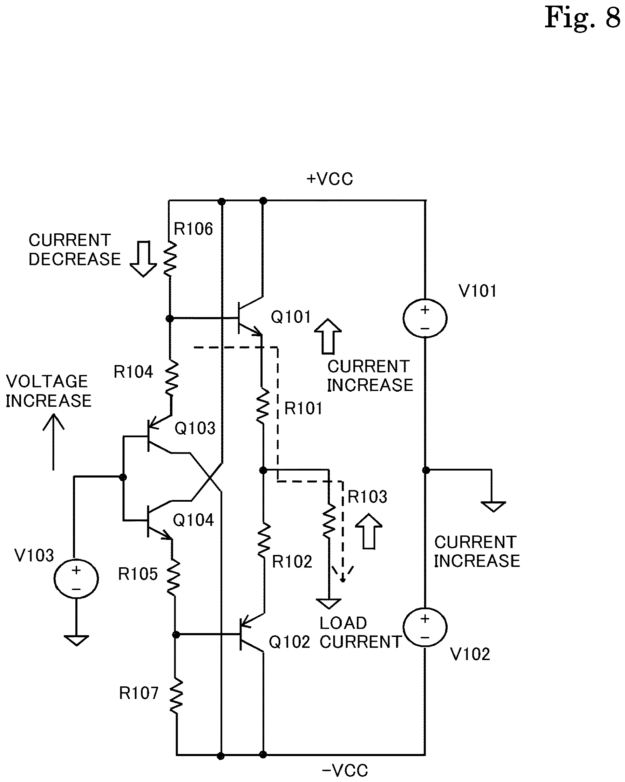

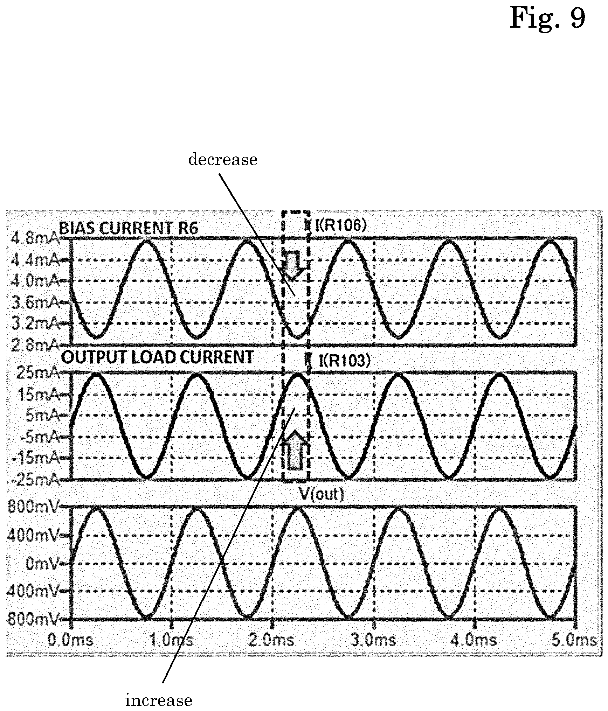

Fig. 8 is a diagram illustrating a constitution of a circuit which is called a diamond buffer (for example, see Fig. 5 of patent literature 1.). As illustrated in Fig. 8, the diamond buffer circuit has bipolar transistors Q101 to Q104 and resistors R101, R102, and R104 to R107. R103 is a load. In the diamond buffer circuit, bias current of output stage base side flows to the resistors R106 and R104. When output voltage rises and current which flows to the load R103 increases, output current of the bipolar transistor Q101 increases and base current increases. For this reason, in bias current, in order to supply this, sufficient current is expected. However, contrary to this, base side bias current decreases (see Fig. 9.). It is because when input voltage rises, base voltage of the bipolar transistor Q103 rises. Along with this, potential of an emitter rises, and potential difference against +VCC becomes small. Bias current is decided by potential difference between emitter potential of the bipolar transistor Q103 and +VCC and a value of the resistor R104. For this reason, when amplitude of output is larger, decrease becomes remarkable. In Fig. 9, an upper graph illustrates bias current, a middle graph illustrates load current, and a lower graph illustrates output voltage.

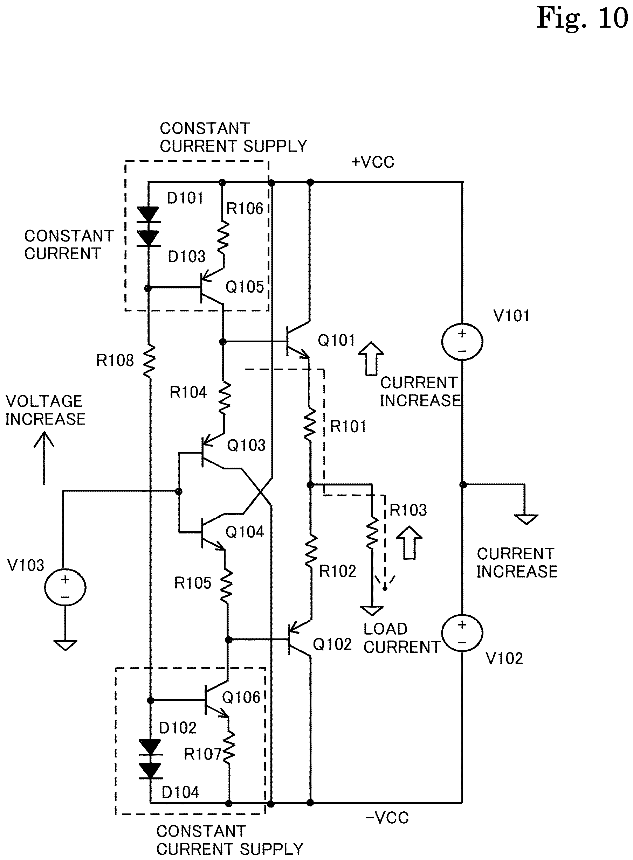

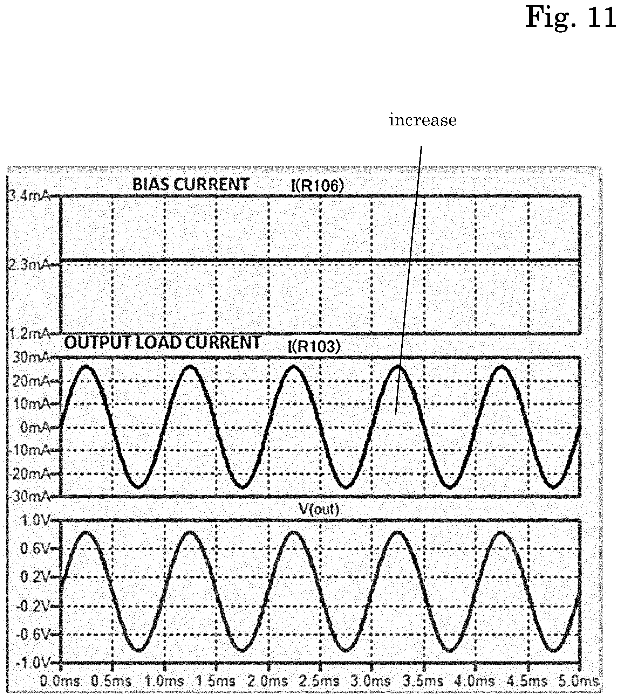

Fig. 10 is a diagram illustrating a constitution of a circuit which solves the above described problem. Compared with Fig. 8, bipolar transistor Q105 and Q106, resistors R106 to R108, and diodes D101 to D104 are added. The diodes D101 and D103, the resistor R106, and the bipolar transistors Q105 constitute a constant current circuit (constant current supply). Further, the diodes D102 and D104, the resistor R107, and the bipolar transistor Q106 constitute a constant current circuit (constant current supply). Decrease of bias current is suppressed by the constant current circuit. Namely, in advance, bias current of constant current is flown, and this current is applied to base current. In this case, when instantaneous current is needed, current not less than decided current cannot be supplied because of constant current (see Fig. 10.). Further, in order to supply sufficient current, it is necessary that current which can correspond to a load is always flown with no load in advance, and loss is large. In Fig. 11, an upper graph illustrates bias current, a middle graph illustrates load current, and a lower graph illustrates output voltage.

### PRIOR ART DOCUMENT

### PATENT LITERATURE

Patent Literature 1: JP 2011-182173 A

### SUMMARY OF THE INVENTION

### PROBLEM TO BE RESOLVED BY THE INVENTION

As described above, in the conventional diamond buffer circuit, when output load becomes large, bias current decreases, and sufficient base current cannot be flown. For this reason, there is a problem that distortion characteristics get worse. As a measure for this problem, there is a system for applying bias current by a constant current supply. In this case, in order to improve distortion, large current is flown in advance, and there is a problem that energy consumption becomes large in no signal.

An objective of the present invention is to provide an amplification device which reduces energy consumption in idling and does not deteriorate distortion characteristics.

### MEANS FOR SOLVING THE PROBLEM

An amplification device of a first invention comprising: an operational amplifier which amplifies an input signal; a diamond buffer circuit to which the signal which is amplified by the operational amplifier is input; and a current mirror circuit which is connected to a power supply and the diamond buffer circuit and is connected to a power supply terminal of the operational amplifier.

In the present invention, a current mirror circuit is connected to a power supply and a diamond buffer circuit. Further, the current mirror circuit is connected to a power supply terminal of an operational amplifier. Power supply current of the operational amplifier is similar to an input signal. Therefore, when the input signal is large, power supply current of the operational amplifier becomes large, and bias current which flows to the diamond buffer circuit becomes large by the current mirror circuit. Thus, sufficient bias current can be flown, and distortion characteristics do not get worse.

Further, when the input signal is small, power supply current of the operational amplifier becomes small, and bias current which flows to the diamond buffer circuit becomes small by the current mirror circuit. Thus, energy consumption does not become large.

In this manner, according to the present invention, energy consumption dose not becomes large in idling, and distortion characteristics do not get worse.

The amplification device of a second invention is the amplification device of the first invention, wherein the current mirror circuit has a first current mirror circuit which is connected to a positive side power supply and the diamond buffer circuit and is connected to a positive side power supply terminal of the operational amplifier, and a second current mirror circuit which is connected to a negative side power supply and the diamond buffer circuit and is connected to a negative side power supply terminal of the operational amplifier.

The amplification device of a third invention is the amplification device of the second invention, wherein the diamond buffer circuit has a pnp type first bipolar transistor in which a collector is connected to the positive side power supply, in which an emitter is connected to a load via a first resistor, and in which a base is connected to an emitter of a third bipolar transistor via a fourth resistor, a pnp type second bipolar transistor in which a collector is connected to a negative side power supply, in which an emitter is connected to the load via a second resistor, and in which a base is connected to an emitter of a fourth bipolar transistor via a fifth resistor, the pnp type third bipolar transistor in which a collector is connected to the negative side power supply, in which an emitter is connectedto the base of the first bipolar transistor and the first current mirror circuit via the fourth resistor, and in which a base is connected to an output terminal of the operational amplifier, and the npn type fourth bipolar transistor in which a collector is connected to the positive side power supply, in which an emitter is connected to the base of the second bipolar transistor and the second current mirror circuit, in which a base is connected to the output terminal of the operational amplifier.

The amplification device of a fourth invention is the amplification device of the third invention, wherein the first current mirror circuit has a pnp type fifth bipolar transistor in which a collector is connected to the diamond buffer circuit, in which an emitter is connected to the positive side power supply via a thirteenth resistor, and in which a base is connected to a base and a collector of a sixth bipolar transistor, and the pnp type sixth bipolar transistor in which a collector is connected to a base, the positive side power supply terminal of the operational amplifier, and the base of the fifth bipolar transistor, in which an emitter is connected to the positive side power supply via a twelfth resistor, in which a base is connected to the collector and the base of the fifth bipolar transistor, and the second current mirror circuit has an npn type seventh bipolar transistor in which a collector is connected to the diamond buffer circuit, in which an emitter is connected to the negative side power supply via a fifteenth resistor, and in which a base is connected to a base and a collector of an eighth bipolar transistor, and the npn type eighth bipolar transistor in which a collector is connected to a base, the negative side power supply terminal of the operational amplifier, and the base of the seventh bipolar transistor, in which an emitter is connected to the negative side power supply via a fourteenth resistor, in which a base is connected to the collector and the base of the seventh bipolar transistor.

The amplification device of a fifth invention is the amplification deice of any one of the first to the fourth inventions, wherein a signal is input to a negative side input terminal of the operational amplifier via an eleventh resistor, a positive side input terminal of the operational amplifier is connected to standard potential, an output terminal of the operational amplifier is connected to a load, a sixth resistor is connected between the output terminal and the negative side input terminal.

### EFFECT OF THE INVENTION

According to the present invention, energy consumption dose not becomes large in idling, and distortion characteristics do not get worse.

### BRIEF DESCRIPTION OF THE DRAWINGS

Fig. 1 is a diagram illustrating a circuit configuration of an amplification device according to an embodiment of the present invention.
Fig. 2 is a graph illustrating base - emitter voltage and the like of a bipolar transistor Q3.
Fig. 3 is a graph illustrating current and the like which flow to a load.
Fig. 4 is a diagram illustrating a configuration of an amplification device which uses a conventional diamond buffer circuit.
Fig. 5 is a diagram illustrating rising in a conventional amplification device.
Fig. 6 is a diagram illustrating rising in the amplification device of the present embodiment.
Fig. 7 is a graph illustrating current and the like which flow to a load.
Fig. 8 is a diagram illustrating a configuration of a diamond buffer circuit.
Fig. 9 is a graph illustrating current and the like which flow to a load.
Fig. 10 is a diagram illustrating a circuit in which a diamond buffer circuit is improved.
Fig. 11 is a graph illustrating current and the like which flow to a load.

### DESCRIPTION OF THE EMBODIMENTS

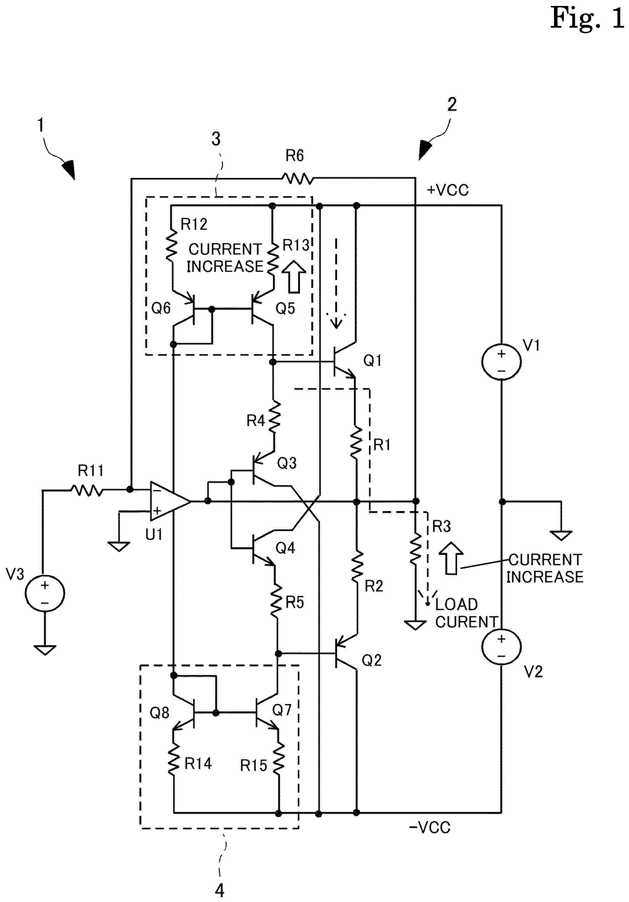

An embodiment of the present invention is described below. Fig. 1 is a diagram illustrating a circuit configuration of an amplification device according to an embodiment of the present invention. As illustrated in Fig. 1, the amplification device 1 includes an operational amplifier U1, a diamond buffer circuit 2, and current mirror circuits 3 and 4.

The operational amplifier U1 amplifies an input signal. The signal is input to a negative side input terminal of the operational amplifier U1. Further, a resistor R11 (eleventh resistor) is connected to the negative side input terminal of the operational amplifier U1. A positive side input terminal of the operational amplifier U1 is connected to a standard potential (ground). An output terminal of the operational amplifier U1 is connected to a load R3 (between a resistor R1 and a resistor R2). A resistor R6 (sixth resistor) is connected between the output terminal of the operational amplifier U1 and the negative side input terminal of the operational amplifier U1. Namely, the operational amplifier U1 and the resistors R6 and R11 compose an inverted amplification circuit.

The signal which is amplified by the operational amplifier U1 is input to the diamond buffer circuit 2. The diamond buffer circuit 2 has bipolar transistors Q1 to Q4 and resistors R1, R2, R4, and R5. The bipolar transistor Q1 (first bipolar transistor) is an npn type bipolar transistor. A collector of the bipolar transistor Q1 is connected to a positive side power supply V1 (+VCC). An emitter of the bipolar transistor Q1 is connected to the load R3 via a resistor R1 (first resistor). A base of the bipolar transistor Q1 is connected to an emitter of the bipolar transistor Q3 via a resistor R4 (fourth resistor).

The bipolar transistor Q2 (second bipolar transistor) is a pnp type bipolar transistor. A collector of the bipolar transistor Q2 is connected to a negative side power supply V2 (-VCC). An emitter of the bipolar transistor Q2 is connected to the load R3 via a resistor R2 (second resistor). A base of the bipolar transistor Q2 is connected to an emitter of the bipolar transistor Q4 via a resistor R5 (fifth resistor).

The bipolar transistor Q3 (third bipolar transistor) is a pnp type bipolar transistor. A collector of the bipolar transistor Q3 is connected to the negative side power supply V2 (-VCC). An emitter of the bipolar transistor Q3 is connected to the base of the bipolar transistor Q1 and the current mirror circuit 3 via the fourth resistor R4.

The bipolar transistor Q4 (fourth bipolar transistor) is an npn type bipolar transistor. A collector of the bipolar transistor Q4 is connected to the positive side power supply V1 (+VCC). An emitter of the bipolar transistor Q4 is connected to the base of the bipolar transistor Q2 and the current mirror circuit 4 via the resistor R5. A base of the bipolar transistor Q4 is connected to the output terminal of the operational amplifier U1.

The current mirror circuit 3 (first current mirror circuit) is connected to the positive side power supply V1 (+VCC) and the diamond buffer circuit 2. Further, the current mirror circuit 3 is connected to a positive side power supply terminal of the operational amplifier U1. The current mirror circuit 3 has bipolar transistors Q5 and Q6 and resistors R12 and R13.

The bipolar transistor Q5 (fifth bipolar transistor) is a pnp type bipolar transistor. A collector of the bipolar transistor Q5 is connected to the diamond buffer circuit 2 (the resistor 4). An emitter of the bipolar transistor Q5 is connected to the positive side power supply V1 (+VCC) via the resistor R13 (thirteenth resistor). A base of the bipolar transistor Q5 is connected to a base and a collector of the bipolar transistor Q6.

The bipolar transistor Q6 (sixth bipolar transistor) is a pnp type bipolar transistor. A collector of the bipolar transistor Q6 is connected to a base, the positive side power supply terminal of the operational amplifier U1, and the base of the bipolar transistor Q5. An emitter of the bipolar transistor Q6 is connected to the positive side power supply V1 (+VCC) via the resistor R12 (twelfth resistor). The base of the bipolar transistor Q6 is connected to the collector and the base of the bipolar transistor Q5.

The current mirror circuit 4 (second current mirror circuit) is connected to the negative side power supply V2 (-VCC) and the diamond buffer circuit 2. Further, the current mirror circuit 4 is connected to the negative side power supply terminal of the operational amplifier U1. The current mirror circuit 4 has bipolar transistors Q7 and Q8, and resistors R14 and R15.

The bipolar transistor Q7 (seventh bipolar transistor) is an npn type bipolar transistor. A collector of the bipolar transistor Q7 is connected to the diamond buffer circuit 2 (resistor R5). An emitter of the bipolar transistor Q7 is connected to the negative side power supply V2 (-VCC) via the resistor R15 (fifteenth resistor). A base of the bipolar transistor Q7 is connected to a base and a collector of the bipolar transistor Q8.

The bipolar transistor Q8 (eighth bipolar transistor) is an npn type bipolar transistor. The collector of the bipolar transistor Q8 is connected to a base, the negative side power supply terminal, of the operational amplifier U1 and the base of the bipolar transistor Q7. An emitter of the bipolar transistor Q8 is connected to the negative side power supply V2 (-VCC) via the resistor R14 (fourteenth resistor). The base of the bipolar transistor Q8 is connected to the collector and the base of the bipolar transistor Q7.

As described above, the current mirror circuit 3 is connected to the positive side power supply V1 (+VCC) and the diamond buffer circuit 2. Further, the current mirror circuit 3 is connected to the positive side power supply terminal of the operational amplifier U1. Herein, power supply current of the operational amplifier U1 is similar to an input signal. Therefore, when an input signal is large, power supply current of the operational amplifier U1 becomes large. For this reason, current which flows to the bipolar transistor Q6 becomes large, and current which flows to the bipolar transistor Q5 becomes large. Thus, even if bias current in no signal is small, distortion characteristics does not get worse because bias current which flows to the resistor R13 becomes large and sufficient current can flows to the base of the bipolar transistor Q1.

Further, when the input signal is small, power supply current of the operational amplifier U1 becomes small and bias current which flows to the resistor R13 becomes small by the current mirror circuit 3. Thus, energy consumption does not become large.

In negative side, the current mirror circuit 4 is connected to the negative side power supply V2 (-VCC) and the diamond buffer circuit 2. Further, the current mirror circuit 4 is connected to the negative side power supply terminal of the operational amplifier U1. Thus, the same operation as the positive side occurs.

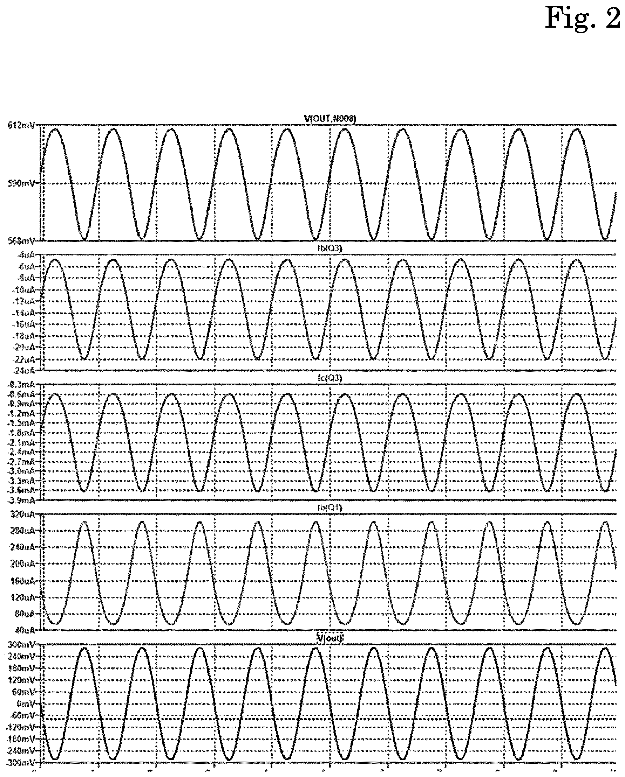

Fig. 2 is a graph illustrating base - emitter voltage of the bipolar transistor Q3. A first graph from top illustrates base - emitter voltage of the bipolar transistor Q3. A second graph illustrates base current of the bipolar transistor Q3. A third graph illustrates collector current of the bipolar transistor Q3. A fourth graph illustrates base current of the bipolar transistor Q1. A fifth graph illustrates output voltage.

As described above, the output terminal of the operational amplifier U1 is connected to a connection point of the resistor R1 which is an output terminal to the load R3 of the diamond buffer circuit 2 and the resistor R2. Thus, with output rising of the operational amplifier U1, base potential of the bipolar transistor Q3 rises, and base - emitter voltage of the bipolar transistor Q3 falls. For this reason, base current of the bipolar transistor Q3 falls, and collector current of the bipolar transistor Q3 falls. Meanwhile, the current mirror circuit 3 by the bipolar transistor Q6 and the bipolar transistor Q5 makes current rises with power supply current of the operational amplifier U1. In this time, collector current of the bipolar transistor Q3 decreases, and current which is supplied by the current mirror circuit 3 can effectively increases bias current of the bipolar transistor Q1 which is flown in order to supply base current of the bipolar transistor Q1 which increases with increase of output voltage.

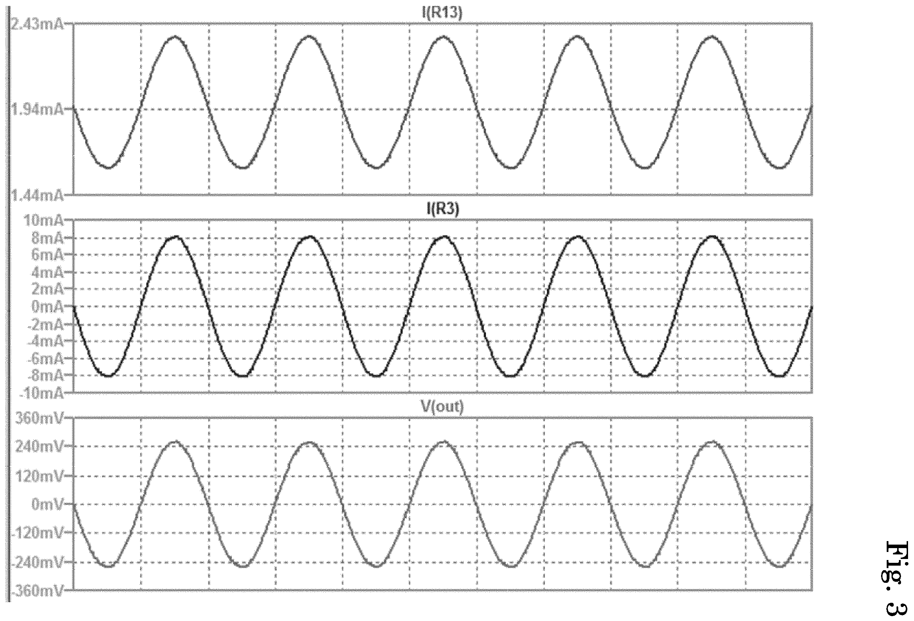

Fig. 3 is a graph illustrating load current. An upper graph illustrates bias current which flows to the resistor R13. A middle graph illustrates output load current which flows to the load R3. A lower graph illustrates output voltage. As illustrated in Fig. 2, when load current increases, bias current also increases.

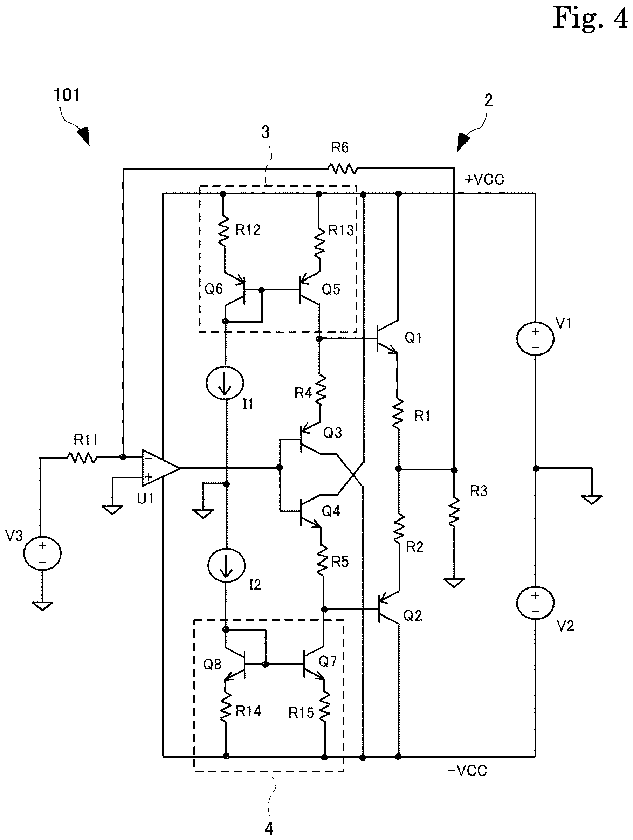

Fig. 4 is a diagram illustrating a configuration of an amplification device which uses a diamond buffer circuit which uses a conventional constant current supply. In an amplification device 101, compared with the amplification device 1 according to the present embodiment, point that the positive side power supply terminal of the operational amplifier U1 is directly connected to the positive side power supply V1 (+VCC), point that the negative side power supply terminal of the operational amplifier U1 is directly connected to the negative side power supply V2 (-VCC), point that the current mirror circuit 3 (the collector of the bipolar transistor Q6) is connected to a current source I1, and point that the current mirror circuit 4 (the collector of the bipolar transistor Q8) is connected to a current source I2 are different.

Herein, the load R3 is set to relatively heavy 8 ohm and 5 mW. In the amplification device 101, bias current is set to 1.99 mA. In the amplification device 1, bias current is set to 1.95 mA as almost the same value as the amplification device 101 or smaller value than the amplification device 101. In this time, in the amplification device 101, collector current of the bipolar transistor Q1 is 24 mA. Further, in the amplification device 1, collector current of the bipolar transistor Q1 is 18.5 mA which is smaller than 24 mA. And, distortion rate of the amplification 101 is 0.003610 %, and distortion rate of the amplification device 1 is 0.000885 %.

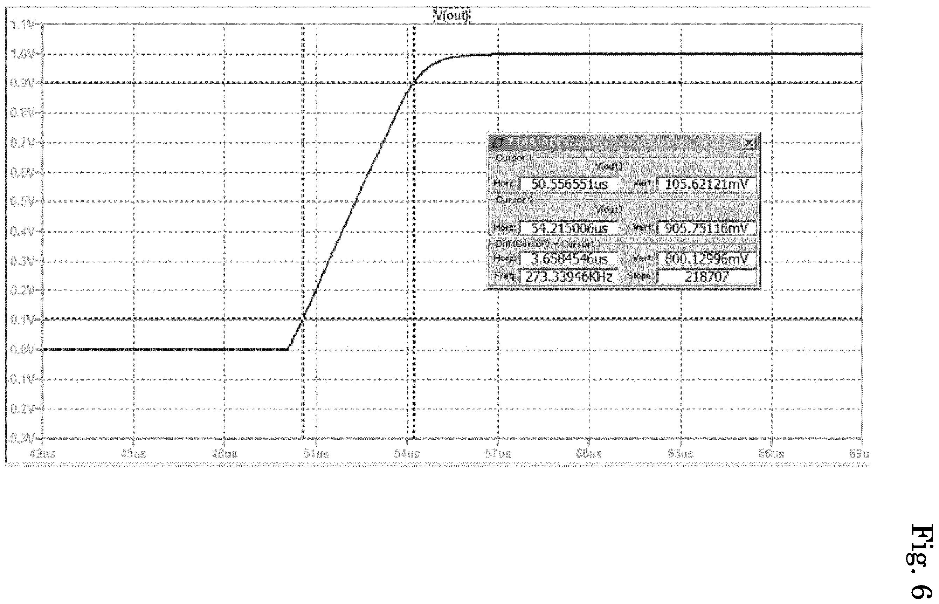

It is thought that current supply ability to a load is improved because bias current decreases or increases based on a signal. Using square wave as input, time of rising (because of inverted output, falling) is measured and compared. As conditions, bias current is arranged and compared. Fig. 5 is a diagram illustrating rising in the conventional amplification device. Fig. 6 is a diagram illustrating rising in the amplification device of the present embodiment. Rising time in the amplification device 101 is 4.6 µS (10 % - 90 %). Rising time in the amplification device is 3.7µS (10 % - 90 %). In this manner, in the amplification device 1, rising of output can be faster than the amplification device 101.

Further, in the amplification device 1 and the conventional amplification device 101, in the same load conditions and the same distortion rate, current which flows to the resistor R13 is compared. Current which flows to the resistor R13 of the amplification device 101 is 1.99 mA. Meanwhile, current which flows to the resistor R13 of the amplification device 1 is 1.39 mA which is smaller than 1.99 mA. In this manner, in the amplification device 1, the same performance as a convention circuit is maintained, and the amplification device 1 can suppress electric power consumption in no signal.

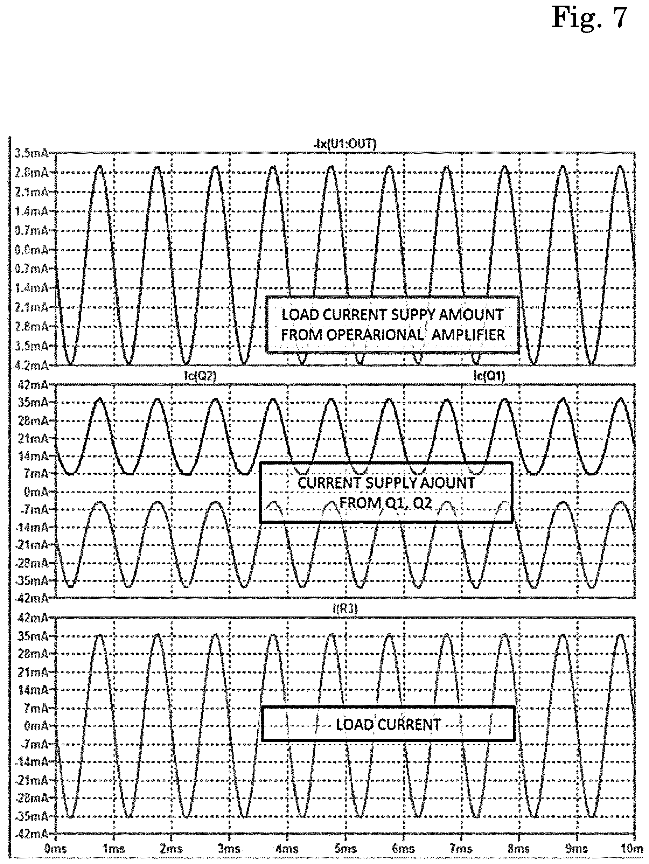

The output terminal of the operational amplifier U1 is connected to the load R3, and current to the load is almost supplied from the bipolar transistors Q1 and Q2 (see Fig. 7.). In Fig. 7, an upper graph illustrates load current supply amount from the operational amplifier U1, a middle graph illustrates load current supply amount from the bipolar transistors Q1 and Q2, and a lower graph illustrates load current.

As described above, in the present embodiment, the current mirror circuits 3 and 4 are connected to the power supply and the diamond buffer circuit 2. Further, the current mirror circuits 3 and 4 are connected to the power supply terminal of the operational amplifier U1. Power supply current of the operational amplifier U1 is similar to the input signal. Therefore, when the input signal is large, power supply current of the operational amplifier U1 becomes large, and current which flows to the diamond buffer circuit 2 becomes large by the current mirror circuits 3 and 4. Thus, sufficient current can be flown, and distortion characteristics do not get worse.

Further, when the input signal is small, power supply current of the operational amplifier U1 becomes small, and current which flows to the diamond buffer circuit 2 becomes small by the current mirror circuits 3 and 4. Thus, energy consumption does not become large.

In this manner, according to the present embodiment, energy consumption dose not becomes large in idling, and distortion characteristics do not get worse.

The embodiment of the present invention is described above, but the mode to which the present invention is applicable is not limited to the above embodiment and can be suitably varied without departing from the scope of the present invention.

### INDUSTRIAL APPICABILITY

The present invention can be suitably employed in an amplification device which amplifies a signal.

Reference signs:
1 Amplification device
2 Diamond buffer circuit
3 Current mirror circuit (first current mirror circuit)
4 Current mirror circuit (second current mirror circuit)
Q1 Bipolar transistor (first bipolar transistor)
Q2 Bipolar transistor (second bipolar transistor)
Q3 Bipolar transistor (third bipolar transistor)
Q4 Bipolar transistor (fourth bipolar transistor)
Q5 Bipolar transistor (fifth bipolar transistor)
Q6 Bipolar transistor (sixth bipolar transistor)
Q7 Bipolar transistor (seventh bipolar transistor)
Q8 Bipolar transistor (eighth bipolar transistor)
R1 Resistor (first resistor)
R2 Resistor (second resistor)
R3 load
R4 Resistor (fourth resistor)
R5 Resistor (fifth resistor)
R6 Resistor (sixth resistor)
R11 Resistor (eleventh resistor)
R12 Resistor (twelfth resistor)
R13 Resistor (thirteenth resistor)
R14 Resistor (fourteenth resistor)
R15 Resistor (fifteenth resistor)
V1 Positive side power supply
V2 Negative side power supply

## Claims

1. An amplification device comprising:
an operational amplifier which amplifies an input signal;
a diamond buffer circuit to which the signal which is amplified by the operational amplifier is input; and
a current mirror circuit which is connected to a power supply and the diamond buffer circuit and is connected to a power supply terminal of the operational amplifier.

2. The amplification device according to claim 1,
wherein the current mirror circuit has
a first current mirror circuit which is connected to a positive side power supply and the diamond buffer circuit and is connected to a positive side power supply terminal of the operational amplifier, and
a second current mirror circuit which is connected to a negative side power supply and the diamond buffer circuit and is connected to a negative side power supply terminal of the operational amplifier.

3. The amplification device according to claim 2,
wherein the diamond buffer circuit has
a pnp type first bipolar transistor
in which a collector is connected to the positive side power supply,
in which an emitter is connected to a load via a first resistor, and
in which a base is connected to an emitter of a third bipolar transistor via a fourth resistor,
a pnp type second bipolar transistor
in which a collector is connected to a negative side power supply,
in which an emitter is connected to the load via a second resistor,
and in which a base is connected to an emitter of a fourth bipolar transistor via a fifth resistor,
the pnp type third bipolar transistor
in which a collector is connected to the negative side power supply,
in which an emitter is connected to the base of the first bipolar transistor and the first current mirror circuit via the fourth resistor, and
in which a base is connected to an output terminal of the operational amplifier, and
the npn type fourth bipolar transistor
in which a collector is connected to the positive side power supply,
in which an emitter is connected to the base of the second bipolar transistor and the second current mirror circuit,
in which a base is connected to the output terminal of the operational amplifier.

4. The amplification device according to claim 3, wherein
the first current mirror circuit has
a pnp type fifth bipolar transistor
in which a collector is connected to the diamond buffer circuit,
in which an emitter is connected to the positive side power supply via a thirteenth resistor,
and in which a base is connected to a base and a collector of a sixth bipolar transistor, and
the pnp type sixth bipolar transistor
in which a collector is connected to a base, the positive side power supply terminal of the operational amplifier, and the base of the fifth bipolar transistor,
in which an emitter is connected to the positive side power supply via a twelfth resistor,
in which a base is connected to the collector and the base of the fifth bipolar transistor, and
the second current mirror circuit has
an npn type seventh bipolar transistor
in which a collector is connected to the diamond buffer circuit,
in which an emitter is connected to the negative side power supply via a fifteenth resistor, and
in which a base is connected to a base and a collector of an eighth bipolar transistor, and
the npn type eighth bipolar transistor
in which a collector is connected to a base, the negative side power supply terminal of the operational amplifier, and the base of the seventh bipolar transistor,
in which an emitter is connected to the negative side power supply via a fourteenth resistor,
in which a base is connected to the collector and the base of the seventh bipolar transistor.

5. The amplification device according to any one of claims 1 to 4, wherein a signal is input to a negative side input terminal of the operational amplifier via an eleventh resistor,
a positive side input terminal of the operational amplifier is connected to standard potential,
an output terminal of the operational amplifier is connected to a load,
a sixth resistor is connected between the output terminal and the negative side input terminal.
